# EUROPÄISCHE PATENTSCHRIFT

(11) **EP 3 113 219 B1**
(45) Veröffentlichungstag und Bekanntmachung des Hinweises auf die Patenterteilung: **11.03.2020**
(21) Anmeldenummer: 15174605.4
(22) Anmeldetag: 30.06.2015
(51) Int. Cl.: H01L 21/683, H01L 21/78, H01L 23/29, H01L 23/31, H01L 29/06, H01L 29/861, H01L 29/74

(54) **HALBLEITERBAUELEMENT UND VERFAHREN ZU DESSEN HERSTELLUNG**
SEMICONDUCTOR DEVICE AND MANUFACTURING METHOD THEREOF
COMPOSANT SEMI-CONDUCTEUR ET PROCEDE DE SA FABRICATION

(43) Veröffentlichungstag der Anmeldung: 04.01.2017
(73) Patentinhaber: SEMIKRON Elektronik GmbH & Co. KG, 90431 Nürnberg (DE)
(72) Erfinder: Luptak, Roman, 92528 Puste Ulany (SK); Krempaská, Olga, 921 01 Piestany (SK); Kubovic, Michal, 90501 Senica (SK)

(56) Entgegenhaltungen:
- EP-A1- 0 019 887
- EP-A1- 1 837 908
- DE-A1- 2 634 568
- FR-A1- 2 406 307
- JP-A- 2009 218 470
- US-A1- 2013 038 390

## Beschreibung

Die Erfindung betrifft ein Halbleiterbauelement und ein Verfahren zur Herstellung von Halbleiterbauelementen.

Insbesondere bei MESA-förmigen bipolaren Halbleiterchips aufweisenden Halbleiterbauelementen besteht oftmals die Notwendigkeit den um die Halbleiterchips umlaufenden Rand der Halbleiterchips gegen Verschmutzung zu schützen, da auf dem Rand der Halbleiterchips angeordnete Schmutzpartikel sich negativ auf die elektrischen Eigenschaften des Halbleiterchips auswirken.

Aus der DE 10 2011 006 492 B3 ist es bekannt, eine aus einem organischen Material bestehende Passivierungsschicht auf die Oberfläche des Rands der Halbleiterchips anzuordnen, die den Rand gegen Verschmutzung und mechanische Einflüsse schützt. Nachteilig dabei ist, dass eine solche aus einem organischen Material bestehende Passivierungsschicht nur unzureichend an der Oberfläche des Rands der Halbleiterchips anhaftet, so dass Schmutzpartikel auf den Rand der Halbleiterchips gelangen können.

Aus der EP 1 837 908 A1 ist ein Leistungshalbleiterbauelement mit einem Halbleiterkörper mit mindestens einem pn- Übergang und mindestens einer auf einer Teilfläche einer Hauptfläche angeordneten Primärpassivierungsschicht bekannt, wobei mindestens eine dieser Primärpassivierungsschichten mittels eines siebdruckfähigen Polyimids als Sekundärpassivierungsschicht überdeckt ist.

Aus der US 2013/0038390 A1 ist ein Leistungsverstärker dessen Rand mit einer Aluminiumoxidschicht bedeckt ist, bekannt.

Aus der EP 0 019 887 A1 ist ein Halbleiterbauelement mit einem Halbleiterkörper, der von einer im wesentlichen isolierende Eigenschaften aufweisenden Hülle umgeben ist, die mindestens teilweise aus einer Kunststoffverguß- oder Preßmasse besteht, bekannt.

Aus der JP 2009 218470 A ist eine Halbleiteranordnung, bei der eine erste Halbleitereinrichtung mit einer zweiten Halbleitereinrichtung mittels Lötkugeln verlötet ist, bekannt.

Aus der DE 26 34 568 A1 ist ein MESA-förmiger Halbleiterchip mit einer Randfläche sowie einer ersten und einer zweiten Schutzschicht bekannt, wobei die beiden Schutzschichten auf der gesamten Randfläche des Halbleiterchips angeordnet sind. Die erste Schutzschicht haftet gut an den Halbleiterchiprandflächen und auch an der zweiten Schutzschicht.

Es ist Aufgabe der Erfindung, ein Halbleiterbauelement mit einem Halbleiterchip zu schaffen, wobei zumindest ein Teil der Randfläche des Halbleiterchips sehr wirksam gegen Verschmutzung geschützt ist.

Die Erfindung ist in den beigefügten Ansprüchen 1 bis 12 dargelegt.

Vorteilhafte Ausbildungen der Erfindung ergeben sich aus den abhängigen Ansprüchen.

Vorteilhafte Ausbildungen des Verfahrens ergeben sich analog zu den vorteilhaften Ausbildungen des Halbleiterbauelements und umgekehrt.

Die Aluminiumoxidschicht ist auf der gesamten Randfläche des Halbleiterchips angeordnet. Hierdurch ist der Rand des Halbleiterchips vollständig vor Verschmutzung geschützt.

Weiterhin erweist es sich als vorteilhaft, wenn die erste Metallisierungsschicht zumindest in einem Abschnitt der Randfläche des Halbleiterchips an die Randfläche des Halbleiterchips heranreicht und die Aluminiumoxidschicht auf zumindest einem, an dem mindestens einen Abschnitt der Randfläche des Halbleiterchips angeordneten, Randflächenabschnitt der ersten Metallisierungsschicht angeordnet ist, da dann auch die Randfläche der ersten Metallisierungsschicht, wenn diese an die Randfläche des Halbleiterchips heranreicht, vor Verschmutzung geschützt ist.

Weiterhin erweist es sich als vorteilhaft, wenn die zweite Metallisierungsschicht zumindest in einem Abschnitt der Randfläche des Halbleiterchips an die Randfläche des Halbleiterchips heranreicht und die Aluminiumoxidschicht auf zumindest einem, an dem mindestens einen Abschnitt der Randfläche des Halbleiterchips angeordneten, Randflächenabschnitt der zweiten Metallisierungsschicht angeordnet ist, da dann auch die Randfläche der zweiten Metallisierungsschicht, wenn diese an die Randfläche des Halbleiterchips heranreicht, vor Verschmutzung geschützt ist.

Auf der Oberfläche der Aluminiumoxidschicht ist eine aus einem vernetzten organischen Material bestehende Schicht angeordnet. Das vernetzte organische Material stellt zusätzlich zur Aluminiumoxidschicht eine weitere Schutzschicht gegen Verschmutzung der Randfläche des Halbleiterchips dar, so dass die Randfläche des Halbleiterchips zweistufig und somit extrem gut gegen Verschmutzung geschützt ist. Weiterhin schützt die aus einem vernetzten organischen Material bestehende Schicht die Randfläche des Halbleiterchips zuverlässig gegen mechanische Einwirkungen von Außen.

Ferner erweist es sich als vorteilhaft, wenn die aus einem vernetzten organischen Material bestehende Schicht auf der gesamten Oberfläche der Aluminiumoxidschicht angeordnet ist. Hierdurch ist die gesamte Randfläche des Halbleiterchips zweistufig und somit extrem gut gegen Verschmutzung geschützt.

Ferner erweist es sich als vorteilhaft, wenn das vernetzte organische Material als vernetzter Silikonkautschuk, als vernetztes Polyimid oder als vernetztes Epoxidharz ausgebildet ist, da diese Materialen besonders wirksam gegen Verschmutzung und mechanische Einflüsse von Außen schützen.

Weiterhin erweist es sich als vorteilhaft, wenn der bipolare Halbleiterchip als Diode, Thyristor oder Bipolartransistor ausgebildet ist. Dioden, Thyristoren oder Bipolartransistoren stellen übliche bipolare Halbleiterelemente dar.

Es erweist sich als vorteilhaft, wenn das unvernetzte organische Material als unvernetzter Silikonkautschuk und das vernetzte organische Material als vernetzter Silikonkautschuk ausgebildet ist, oder wenn das unvernetzte organische Material als unvernetztes Polyimid und das vernetzte organische Material als vernetztes Polyimid ausgebildet ist, oder wenn das unvernetzte organische Material als unvernetztes Epoxidharz und das vernetzte organische Material als vernetztes Epoxidharz ausgebildet ist, da diese Materialien in ihrem unvernetzten Zustand auf einfache Art und Weise auf die Oberfläche der Aluminiumoxidschicht aufgetragen werden können und diese Materialen in ihrem vernetzten Zustand wirksam gegen Verschmutzung und mechanische Einflüsse von Außen schützen.

Weiterhin erweist es sich als vorteilhaft, wenn zwischen Verfahrensschritt d) und e) folgender Verfahrensschritt erfolgt:
d1) Reinigen des ersten und zweiten Randflächenbereichs, insbesondere durch Ätzen des ersten und zweiten Randflächenbereichs.

Hierdurch wird eine besonderes gute spätere Anhaftung der Aluminiumoxidschicht auf der Oberfläche der Randfläche des jeweiligen Halbleiterchips sichergestellt.

Weiterhin erweist es sich als vorteilhaft, wenn zwischen Verfahrensschritt b) und c) oder zwischen Verfahrensschritt c) und d) ein Verbinden der zweiten Metallisierungsschicht mit einer Folie erfolgt und unmittelbar nach Verfahrensschritt d) die Folie derart auseinandergezogen wird, dass die Abstände der Halbleiterchips voneinander vergrößert werden. Hierdurch wird das Aufbringen der Aluminiumoxidschicht auf die Oberfläche der Randfläche des jeweiligen Halbleiterchips erleichtert.

Ferner erweist es sich als vorteilhaft, wenn im Verfahrensschritt e) das Aufbringen der Aluminiumoxidschicht auf die Oberfläche der Randfläche des jeweiligen Halbleiterchips mittels eines chemischen Gasphasenabscheideverfahrens, das insbesondere als ALD-Verfahren ausgebildet ist, durchgeführt wird, da mittels ein chemisches Gasphasenabscheideverfahrens, insbesondere mittels eines ALD-Verfahren (Atomic Layer Deposition), die Aluminiumoxidschicht mit hoher Qualität auf die Oberfläche der Randfläche des jeweiligen Halbleiterchips aufgebracht werden kann.

Ferner erweist sich folgender Verfahrensschritt am Ende des Verfahrens als vorteilhaft, falls die Halbleiterchips noch direkt oder indirekt über mindestens einen Werkstoff entlang der Grenzen der Halbleiterchipbereiche miteinander verbunden sind:
g) Durchtrennen des mindestens einen Werkstoffs entlang der Grenzen der Halbleiterchipbereiche.

Hierdurch wird eine Vereinzelung der Halbleiterbauelemente durchgeführt, falls diese nicht schon durch die Durchführung von vorhergehenden Verfahrensschritten bereits vereinzelt sind.

Ausführungsbeispiele der Erfindung sind in den Figuren dargestellt und werden im Folgenden näher erläutert. Dabei zeigen:
- FIG 1: eine Ansicht von oben auf einen bipolaren Halbleiterchip,
- FIG 2: eine Schnittansicht einer Ausbildung eines erfindungsgemäßen Halbleiterbauelements,
- FIG 3: eine Schnittansicht einer weiteren Ausbildung eines erfindungsgemäßen Halbleiterbauelements,
- FIG 4: eine Schnittansicht einer weiteren Ausbildung eines erfindungsgemäßen Halbleiterbauelements,
- FIG 5: eine Ansicht von oben auf einen bipolaren Halbleiterwafer,
- FIG 6: eine Ansicht von unten auf einen bipolaren Halbleiterwafer,
- FIG 7: eine Schnittansicht eines Ausschnitts eines bipolaren Halbleiterwafers,
- FIG 8: eine Schnittansicht eines Ausschnitts eines metallisierten bipolaren Halbleiterwafers, auf dessen erste Metallisierungsschicht eine erste Harzschicht angeordnet ist und dessen zweite Metallisierungsschicht mittels einer zweiten Harzschicht mit einer Folie verbunden ist,
- FIG 9: eine Anordnung gemäß FIG 8, wobei der metallisierte bipolare Halbleiterwafer mit Ausnehmungen versehen ist,
- FIG 10: eine Anordnung gemäß FIG 8, wobei der metallisierte bipolare Halbleiterwafer mit Ausnehmungen versehen ist,
- FIG 11: eine Schnittansicht eines Ausschnitts eines mit Ausnehmungen versehenen metallisierten bipolaren Halbleiterwafers bei dem die Halbleiterchips vereinzelt sind, wobei auf der ersten Metallisierungsschicht des metallisierten bipolaren Halbleiterwafers eine ersten Harzschicht angeordnet ist und die zweite Metallisierungsschicht des metallisierten bipolaren Halbleiterwafers mittels einer zweiten Harzschicht mit einer Folie verbunden ist,
- FIG 12: eine Anordnung gemäß FIG 11, wobei die Folie auseinandergezogen ist,
- FIG 13: eine Anordnung gemäß FIG 12, wobei ein unvernetztes organisches Material auf die Oberfläche der Aluminiumoxidschicht aufgebracht ist, das vernetzt wird,
- FIG: 14 eine Anordnung gemäß FIG 13, wobei die erste Harzschicht, die zweite Harzschicht und die Folie entfernt ist und
- FIG: 15 eine Anordnung gemäß FIG 14, wobei die hergestellten Halbleiterbauelemente vereinzelt sind.

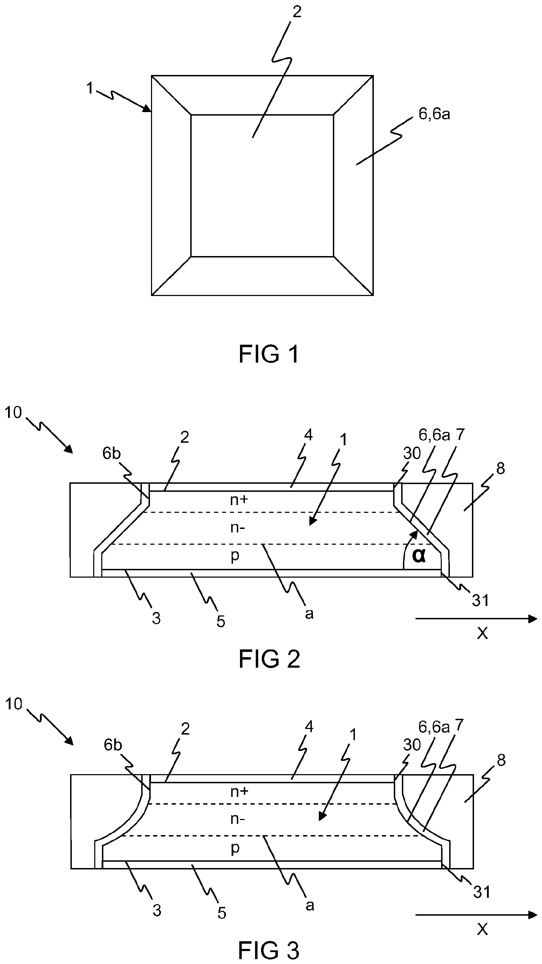

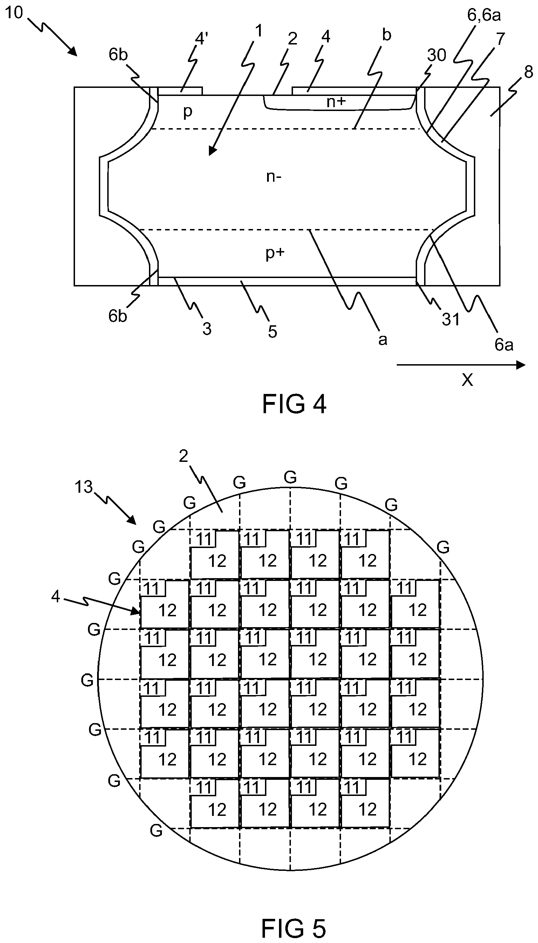

In FIG 1 ist eine Ansicht von oben auf einen Halbleiterchip 1 und in FIG 2 ist eine Schnittansicht einer Ausbildung eines erfindungsgemäßen Halbleiterbauelements 10, das den Halbleiterchip 1 aufweist, dargestellt. Der Halbleiterchip 1 ist als bipolarer Halbleiterchip ausgebildet, d.h. der Halbleiterchip ist derart dotiert, dass zum Stromtransport des durch den bipolaren Halbleiterchip 1 zumindest im Wesentlichen fließenden Stroms als Ladungsträger sowohl negativ geladene Elektronen als auch positiv geladene Löcher, die fachspezifisch auch als sogenannte positiv geladene Defektelektronen bezeichnet werden, beitragen. Der bipolare Halbleiterchip 1 kann z.B. als Diode, Bipolartransistor oder als Thyristor ausgebildet sein, wobei er bei den Ausführungsbeispielen gemäß FIG 2 und FIG 3 als Diode ausgebildet ist und in FIG 4 als Thyristor ausgebildet ist.

Der Halbleiterchip 1 weist eine MESA-förmige, d.h. tafelbergförmige Form auf. Auf einer ersten Hauptfläche 2 des Halbleiterchips 1 ist eine erste Metallisierungsschicht 4 angeordnet und auf einer der ersten Hauptfläche 2 des Halbleiterchips 1 gegenüberliegend angeordneten zweiten Hauptfläche 3 des Halbleiterchips 1 ist eine zweite Metallisierungsschicht 5 angeordnet. Die erste und zweite Metallisierungsschicht 4 und 5 weisen vorzugsweise jeweilig mehrere übereinander liegende elektrisch leitende Schichten auf. Im Rahmen des Ausführungsbeispiels weist die erste und zweite Metallisierungsschicht 4 und 5 jeweilig eine auf der ersten Hauptfläche 2 des Halbleiterchips 1 angeordnete Nickelsilizidschicht (100nm bis 300nm, insbesondere 200nm dick), eine auf der Nickelsilizidschicht angeordnete Nickelschicht (600nm bis 1000nm, insbesondere 800nm dick) und eine auf der Nickelschicht angeordnete Goldschicht (10nm bis 30nm, insbesondere 20nm dick) auf. Die erste und zweite Metallisierungsschicht 4 und 5 dienen zur elektrischen Kontaktierung des Halbleiterchips 1.

Der bipolare Halbleiterchip 1 besteht vorzugsweise aus Silizium, das techniküblich dotiert ist. Der Halbleiterchip 1 weist vorzugsweise eine die erste Hauptfläche 2 des Halbleiterchips 1 ausbildende n-dotierte Schicht n+ und eine die zweite Hauptfläche 3 des Halbleiterchips 1 ausbildende p-dotierte Schicht p auf. Zwischen der n-dotierten Schicht n+ und der p-dotierten Schicht p ist eine weitere n-dotierte Schicht n-angeordnet, wobei die Dotierungskonzentration der weiteren n-dotierten Schicht n-geringer ist als die Dotierungskonzentration der n-dotierten Schicht n+. Die n-dotierten Schichten n+ und n- können z.B. durch Diffusion von Phosphor in das Silizium und die p-dotierte Schicht p z.B. durch Diffusion von Bor in das Silizium entstanden sein. Die n-dotierte Schicht n+ weist vorzugsweise eine Dicke von 60µm bis 100µm, insbesondere von 75µm, und vorzugsweise eine Dotierungskonzentration von 4x10²⁰cm⁻³ bis 12x10²⁰cm⁻³, insbesondere von 8x10²⁰cm⁻¹, auf. Die weitere n-dotierte Schicht n- weist vorzugsweise eine Dicke von 170µm bis 200µm, insbesondere von 185µm, und vorzugsweise eine Dotierungskonzentration von 3x10¹³cm⁻³ bis 9x10¹³cm⁻³, insbesondere von 6x10¹³cm⁻³, auf. Die p-dotierte Schicht p weist vorzugsweise eine Dicke von 75µm bis 105µm, insbesondere von 90µm, und vorzugsweise eine Dotierungskonzentration von 1x10²⁰cm⁻³ bis 7x10²¹cm⁻³, insbesondere von 4x10²¹cm⁻³, auf.

An der Grenze a zwischen der weiteren n-dotierten Schicht n- und der p-dotierten Schicht p bildet sich ein pn-Übergang aus. Der Halbleiterchip 1 weist vorzugsweise eine Dicke von 305 µm bis 405µm, insbesondere von 350µm, auf.

Der Halbleiterchip 1 weist eine um den Halbleiterchip 1 umlaufende die erste und zweite Hauptfläche 2 und 3 verbindende Randfläche 6 auf.

Auf der Randfläche 6 des Halbleiterchips 1 ist eine Aluminiumoxidschicht (Al₂O₃) 7 angeordnet. Die Aluminiumoxidschicht 7 haftet sehr gut auf der Randfläche 6 des Halbleiterchips 1, so dass in den Bereichen der Randfläche 6, die von der Aluminiumoxidschicht 7 bedeckt sind, keine Schmutzpartikel und auch keine Luft auf die Randfläche 6 des Halbleiterchips 1 gelangen können, die dessen elektrische Eigenschaften negativ beeinflussen können. Die Aluminiumoxidschicht 7 weist vorzugsweise eine Dicke von 5nm bis 100nm, insbesondere eine Dicke von 15nm bis 25nm und insbesondere eine Dicke von 20nm auf. Die Randfläche 6 weist einen um den Halbleiterchip 1 umlaufenden Randflächenabschnitt 6a auf, der wie beispielhaft in FIG 2 dargestellt, einen schrägen Verlauf oder wie beispielhaft in FIG 3 dargestellt einen konkaven Verlauf aufweist, so dass der Halbleiterchip 1 eine MESA-förmige Form aufweist. Der schräg oder konkav verlaufende Randflächenabschnitt 6a verläuft vorzugsweise zumindest im Bereich des pn-Übergangs des Halbleiterchips 1. Der schräg verlaufende Randflächenabschnitt 6a verläuft im Rahmen des Ausführungsbeispiels im gesamten Bereich der weiteren n-dotierten Schicht n- und reicht in den Bereich der n-dotierten Schicht n+ und der p-dotierten Schicht p hinein. Der schräg verlaufende Randflächenabschnitt 6a weist vorzugsweise im Bezug zur zweiten Hauptfläche 3 des Halbleiterchips 1 einen Winkel α von 10° bis 40° und insbesondere von 30° aus. Die Randfläche 6 weist vorzugsweise einen, um den Halbleiterchip 1 umlaufenden, von der ersten Hauptfläche 2 des Halbleiterchips 1 zum Randflächenabschnitt 6a im Bezug zur ersten Hauptfläche 2 senkrecht verlaufenden, weiteren Randflächenabschnitt 6b auf. Die Aluminiumoxidschicht 7 bedeckt den Bereich des pn-Übergangs des Halbleiterchips 1 und den gesamten schräg oder konkav verlaufenden Randflächenabschnitt 6a. Die Aluminiumoxidschicht 7 ist auf der gesamten Randfläche 6 des Halbleiterchips 1 angeordnet. Hierdurch ist die gesamte Randfläche 6 des Halbleiterchips 1 sehr wirksam gegen Verschmutzung geschützt.

Vorzugsweise reicht die erste Metallisierungsschicht 4 zumindest in einem Abschnitt der Randfläche 6 des Halbleiterchips 1 an die Randfläche 6 des Halbleiterchips 1 heran und die Aluminiumoxidschicht 7 ist vorzugsweise zumindest auf einem, an dem mindestens einen Abschnitt der Randfläche 6 des Halbleiterchips 1 angeordneten, Randflächenabschnitt 30 der ersten Metallisierungsschicht 4 angeordnet. Hierdurch ist auch der betreffende Randflächenabschnitt 30 oder die betreffenden Randflächenabschnitte 30 der ersten Metallisierungsschicht 4 wirksam gegen Verschmutzung geschützt. Im Rahmen des Ausführungsbeispiels gemäß FIG 2 und FIG 3 reicht die gesamte Randfläche der ersten Metallisierungsschicht 4 an die Randfläche 6 des Halbleiterchips 1 heran und die Aluminiumoxidschicht 7 ist auf der gesamten Randfläche der ersten Metallisierungsschicht 4 angeordnet.

Vorzugsweise reicht die zweite Metallisierungsschicht 5 zumindest in einem Abschnitt der Randfläche 6 des Halbleiterchips 1 an die Randfläche 6 des Halbleiterchips 1 heran und die Aluminiumoxidschicht 7 ist vorzugsweise zumindest auf einem, an dem mindestens einen Abschnitt der Randfläche 6 des Halbleiterchips 1 angeordneten, Randflächenabschnitt 31 der zweiten Metallisierungsschicht 5 angeordnet. Hierdurch ist auch der betreffende Randflächenabschnitt 31 oder die betreffenden Randflächenabschnitte 31 der zweiten Metallisierungsschicht 5 wirksam gegen Verschmutzung geschützt. Im Rahmen des Ausführungsbeispiels gemäß FIG 2 und FIG 3 reicht die gesamte Randfläche der zweiten Metallisierungsschicht 5 an die Randfläche 6 des Halbleiterchips 1 heran und die Aluminiumoxidschicht 7 ist auf der gesamten Randfläche der zweiten Metallisierungsschicht 5 angeordnet.

Auf der Oberfläche der Aluminiumoxidschicht 7 ist eine aus einem vernetzten organischen Material bestehende Schicht 8 angeordnet. Die aus einem vernetzten organischen Material bestehende Schicht 8 ist dabei vorzugsweise auf der gesamten Oberfläche der Aluminiumoxidschicht 7 angeordnet. Das vernetzte organische Material ist nicht elektrisch leitet. Das vernetzte organische Material ist vorzugsweise als vernetzter Silikonkautschuk, als vernetztes Polyimid oder als vernetztes Epoxidharz ausgebildet. Der vernetzte Silikonkautschuk besteht vorzugsweise im Wesentlichen aus Polysiloxan, insbesondere ausschließlich aus Polysiloxan. Das betreffende organische Material wird bei der Herstellung des Halbleiterbauelements 10 in seinem unvernetzten Zustand, bei der es eine flüssige oder gelförmige Konsistenz aufweist, auf die Aluminiumoxidschicht 7 aufgebracht und anschließend durch z.B. Verdunstung und/oder Hitzeeinwirkung und/oder Lichteinwirkung vernetzt. Die Vernetzung geschieht im Allgemeinen durch Polymerisation bzw. Polykondensation. Das vernetzte organische Material weist, abhängig vom organischen Material, eine gummiähnliche oder duroplastische Konsistenz auf. Das vernetzte organischen Material stellt zusätzlich zur Aluminiumoxidschicht 7 eine weitere Schutzschicht gegen Verschmutzung der Randfläche 6 des Halbleiterchips 1 dar, so dass die Randfläche 6 des Halbleiterchips 1 zweistufig und somit extrem gut gegen Verschmutzung geschützt ist. Weiterhin schützt die aus einem vernetzten organischen Material bestehende Schicht 8 die Randfläche 6 des Halbleiterchips 1 zuverlässig gegen mechanische Einwirkungen von Außen. Im allgemeinen weist die Schicht 8 in paralleler Richtung X zur zweiten Hauptfläche 3 des Halbleiterchips 1 eine schwankende Dicke auf. Die aus dem vernetzten organischen Material bestehende Schicht 8 weist vorzugsweise in paralleler Richtung X zur zweiten Hauptfläche 3 des Halbleiterchips 1 eine durchschnittliche Dicke von 0,5µm bis 2000µm, insbesondere von 1µm bis 20µm auf.

Die Aluminiumoxidschicht 7 weist weiterhin den großen Vorteil auf, dass das vernetzte organische Material wesentlich besser an ihr haftet als das vernetzte organische Material am Halbleiterchip 1 haftet. Die Aluminiumoxidschicht 7 hat somit auch die Funktion einer Haftvermittlungsschicht zwischen dem vernetzten organischen Material und dem Halbleiterchip 1. Die aus dem vernetzten organischen Material bestehende Schicht 8 ist somit gegenüber den Stand der Technik wesentlich besser an den Halbleiterchip 1 angekoppelt.

In dem Ausführungsbeispiel gemäß FIG 4, bei dem der Halbleiterchip 1 beispielhaft als Thyristor ausgebildet ist, weist der Halbleiterchip 1 um den Halbleiterchip 1 vorzugsweise mindestens zwei um den Halbleiterchip 1 umlaufende Randflächenabschnitte 6a auf, die, wie beispielhaft in FIG 4 dargestellt, einen konkaven Verlauf aufweisen. Anstatt des konkaven Verlaufs können die mindestens zwei Randflächenabschnitte 6a aber z.B. auch einen schrägen Verlauf aufweisen, oder einer der beiden einen konkaven Verlauf und der andere einen schrägen Verlauf aufweisen. Es sei dabei angemerkt, dass im Sinne der Erfindung auch die in FIG 4 dargestellte geometrische Form des Halbleiterchips 1 einschließlich eventuell alternativ vorhandener schräg verlaufender Randflächenabschnitte 6a oder eines eventuell alternativ vorhandenen schräg verlaufenden Randflächenabschnitts 6a, im Sinne der Erfindung als MESA-förmig angesehen wird.

Der Halbleiterchip 1 weist beim Ausführungsbeispiel gemäß FIG 4 eine dritte Metallisierungsschicht 4' auf, die auf der ersten Hauptfläche 2 des Halbleiterchips 1 angeordnet ist. Die dritte Metallisierungsschicht 4' ist vorzugsweise identisch wie die erste Metallisierungsschicht 4 aufgebaut. Die dritte Metallisierungsschicht 4' dient zur elektrischen Kontaktierung des Halbleiterchips 1 und bildet vorzugsweise den Gateanschluss des Thyristors aus. Der Halbleiterchip 1 weist eine fachübliche allgemein bekannte Dotierung zur Realisierung eines Thyristors aus, wobei in FIG 4 die n-dotierten und p-dotierten Schichten dargestellt sind, dabei bedeutet ein "+" eine höhere Dotierungskonzentration und ein "-" eine niedrigere Dotierungskonzentration. An den Grenze b der p-dotierten Schicht p und der schwächer n-dotierten Schicht n-bildet sich ein pn-Übergang aus. An den Grenze a der stärker p-dotierten Schicht p+ und der schwächer n-dotierten Schicht n- bildet sich ein weiterer pn-Übergang aus. Der jeweilige schräg oder konkav verlaufende Randflächenabschnitt 6a verläuft vorzugsweise zumindest im Bereich des jeweiligen pn-Übergangs des Halbleiterchips 1.

Das Ausführungsbeispiel gemäß FIG 4 entspricht einschließlich vorteilhafter Ausbildungen ansonsten den zuvor bezüglich der Figuren 1 bis 3 beschrieben Ausführungsbeispielen, so dass bezüglich einer weiteren Beschreibung des Ausführungsbeispiels gemäß FIG 4 auf die dortige Beschreibung verwiesen wird. In FIG 4 sind gleiche Elemente mit den gleichen Bezugszeichen versehen wie in den Figuren 1 bis 3.

Im Folgenden wird ein erfindungsgemäßes Verfahren zur Herstellung von erfindungsgemäßen Halbleiterbauelementen 10 beschrieben.

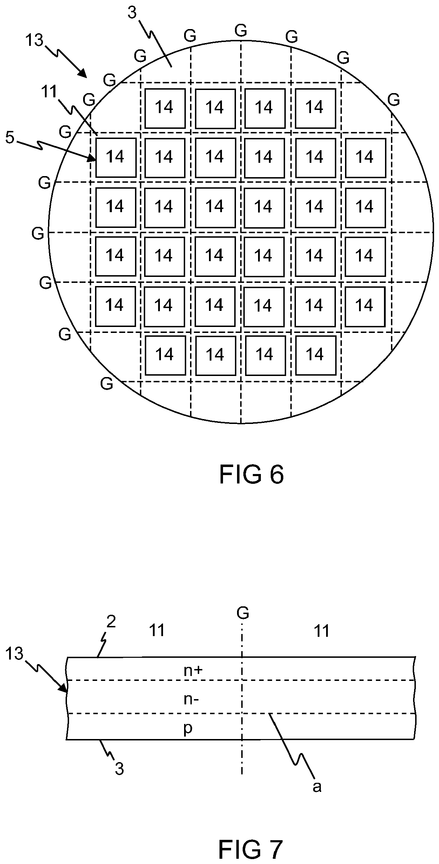

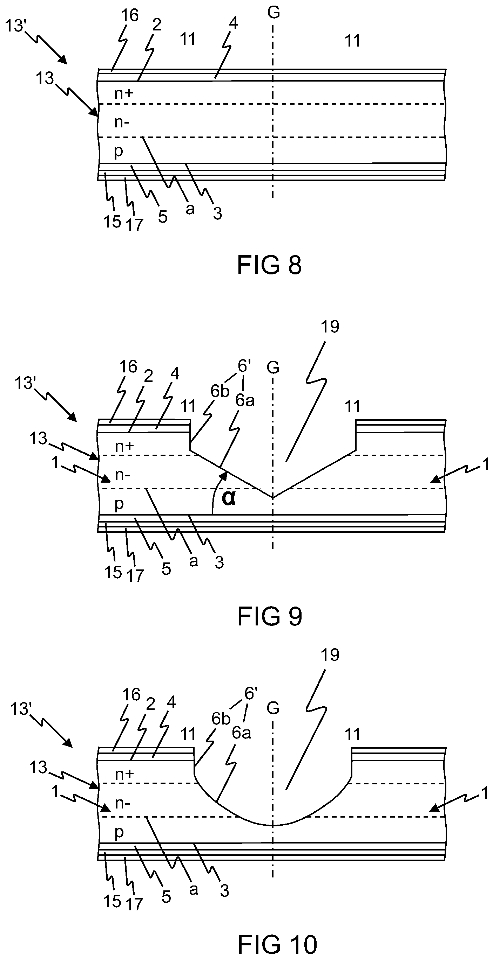

In FIG 5 ist eine Ansicht von oben und in FIG 6 von unten auf einen bipolaren Halbleiterwafer 13 dargestellt. In FIG 7 ist eine Schnittansicht eines Ausschnitts eines bipolaren Halbleiterwafers 13 dargestellt. In FIG 8 ist ein mit einer ersten und zweiten Metallisierungsschicht 4 und 5 versehener bipolarer Halbleiterwafer 13, d.h. ein metallisierter bipolarer Halbleiterwafer 13' dargestellt.

In einem ersten Verfahrensschritt erfolgt ein Bereitstellen eines bipolaren Halbleiterwafers 13, wobei dem bipolaren Halbleiterwafer 13 Halbleiterchipbereiche 11 zugeordnet sind, an denen jeweilig ein Halbleiterchip 1 ausgebildet werden soll. Die Halbleiterchipbereiche 11 weisen Grenzen G auf, die die Halbleiterchipbereiche 11 voneinander trennen. Der Halbleiterwafer 13 ist als bipolarer Halbleiterwafer ausgebildet, d.h. der Halbleiterwafer 13 ist derart dotiert, dass zum Stromtransport des durch den Halbleiterwafer 13 zumindest im Wesentlichen fließenden Stroms als Ladungsträger sowohl negativ geladene Elektronen als auch positiv geladene Löcher, beitragen. Der Halbleiterwafer 13 besteht vorzugsweise aus Silizium, das identisch wie der zuvor beschriebene bipolare Halbleiterchip 1 dotiert ist und somit identisch dotierte Schichten wie der zuvor beschriebene bipolare Halbleiterchip 1 aufweist. An der Grenze a zwischen der weiteren n-dotierten Schicht n- und der p-dotierten Schicht p bildet sich ein pn-Übergang aus. In FIG 5 weist der bipolare Halbleiterwafer 13 einen Schichtaufbau wie der Halbleiterchip 1 gemäß FIG 2 und FIG 3 auf. Selbstverständlich kann der Halbleiterwafer 13 aber auch einen Schichtaufbau wie der Halbleiterchip 1 gemäß FIG 4 oder einen anderen Schichtaufbau aufweisen, der einen bipolaren Halbleiterwafer realisiert.

In einem weiteren Verfahrensschritt erfolgt ein Ausbilden eines metallisierten bipolaren Halbleiterwafers 13' durch Aufbringen einer ersten Metallisierungsschicht 4 auf eine erste Hauptfläche 2 des bipolaren Halbleiterwafers 13 zumindest in einem jeweiligen ersten Teilbereich 12 der Halbleiterchipbereiche 11 und Aufbringen einer zweiten Metallisierungsschicht auf einer der ersten Hauptfläche 2 des bipolaren Halbleiterwafers 13' gegenüberliegend angeordneten zweiten Hauptfläche 3 des bipolaren Halbleiterwafers 13 zumindest in einem jeweiligen zweiten Teilbereich 14 der Halbleiterchipbereiche 11. Gegebenenfalls kann, falls der spätere jeweilige Halbleiterchip z.B. als Thyristor oder Bipolartransistor ausgebildet sein soll, auf der ersten Hauptfläche 2 des bipolaren Halbleiterwafers 13 eine dritte Metallisierungsschicht aufgebracht werden, die später den Gateanschluss des Halbleiterchips ausbildet. Die erste bzw. zweite Metallisierungsschicht 4 und 5 können aber auch, wie in FIG 8 dargestellt, auf der gesamten Fläche der Halbleiterchipbereiche 11 und solchermaßen auf der gesamten Fläche der jeweiligen Hauptflächen 2 und 3 des Halbleiterwafers 13 aufgebracht werden. Dies ist besonders vorteilhaft, wenn der spätere jeweilige Halbleiterchip als Diode ausgebildet sein soll. Die erste und zweite Metallisierungsschicht des metallisierten bipolaren Halbleiterwafers 13' können somit jeweilig strukturiert oder unstrukturiert ausgebildet sein. Die auf den bipolaren Halbleiterwafer 13 aufgebrachte erste und zweite Metallisierungsschicht 4 und 5 sind bezüglich ihres Schichtaufbaus und den Materialen der Schichten identisch wie die zuvor beschriebene erste und zweite Metallisierungsschicht des Halbleiterbauelements 10 ausgebildet.

In einem weiteren vorzugsweise durchzuführenden Verfahrensschritt erfolgt ein Verbinden der zweiten Metallisierungsschicht 5 mit einer Folie 17 über vorzugsweise eine erste Harzschicht 15. Die erste Harzschicht 15 ist zwischen der zweiten Metallisierungsschicht 5 und der Folie 17 angerordnet. Die erste Harzschicht 15 kann dabei beim Verbinden der zweiten Metallisierungsschicht 5 mit der Folie 17 bereits auf die Folie 17 aufgebracht sein oder sie wird vor dem Verbinden auf die zweite Metallisierungsschicht 5 aufgebracht. Weiterhin wird vorzugsweise ein zweite Harzschicht 16 auf die erste Metallisierungsschicht 4 aufgebracht. Es sei angemerkt, dass der Verfahrensschritt des Verbindens der zweiten Metallisierungsschicht 5 mit der Folie 17 auch zwischen den nachfolgend beschriebenen Verfahrensschritten des Ausbildens von Ausnehmungen und der Vereinzelung der Halbleiterchips erfolgen kann.

In einem weiteren Verfahrensschritt dessen Ergebnis in FIG 9 bzw. FIG 10 dargestellt ist, erfolgt eine Ausbildung von Ausnehmungen 19 im metallisierten bipolaren Halbleiterwafer 13' entlang der Grenzen G der Halbleiterchipbereiche 11, wodurch sich in einem Waferverbund miteinander verbundene Halbleiterchips 1 ausbilden, wobei die Ausnehmungen 19 eine derartige Form aufweisen, dass ein um den jeweiligen Halbleiterchip 1 umlaufender erster Randflächenbereich 6' des jeweiligen Halbleiterchips 1 ausbildet wird, der mindestens einen schräg (siehe FIG 9) oder konkav (siehe FIG 10) verlaufenden Randflächenabschnitt 6a aufweist. Der schräg oder konkav verlaufende Randflächenabschnitt 6a verläuft vorzugsweise mindestens im Bereich des jeweiligen pn-Übergangs des Halbleiterchips 1. Der schräg verlaufende Randflächenabschnitt 6a weist vorzugsweise im Bezug zur zweiten Hauptfläche 3 des metallisierten bipolaren Halbleiterwafers 13' einen Winkel α von 10° bis 40° und insbesondere von 30° aus. Der erste Randflächenbereich 6' weist vorzugsweise einen von der ersten Hauptfläche 2 des metallisierten bipolaren Halbleiterwafers 13' zum Randflächenabschnitt 6a im Bezug zur ersten Hauptfläche 2 senkrecht verlaufenden weiteren Randflächenabschnitt 6b auf. Die Ausnehmungen 19 werden vorzugsweise mittels eines Sägewerkzeugs durch Sägen erzeugt, dessen geometrische Form im Sägebereich korrespondierend zur geometrischen Form der Ausnehmungen 19 ausgebildet ist. Alternativ können im Falle eines konkav verlaufenden Randflächenabschnitts 6a die Ausnehmungen zumindest im Bereich des konkav verlaufenden Randflächenabschnitts 6a auch durch Ätzen erzeugt werden.

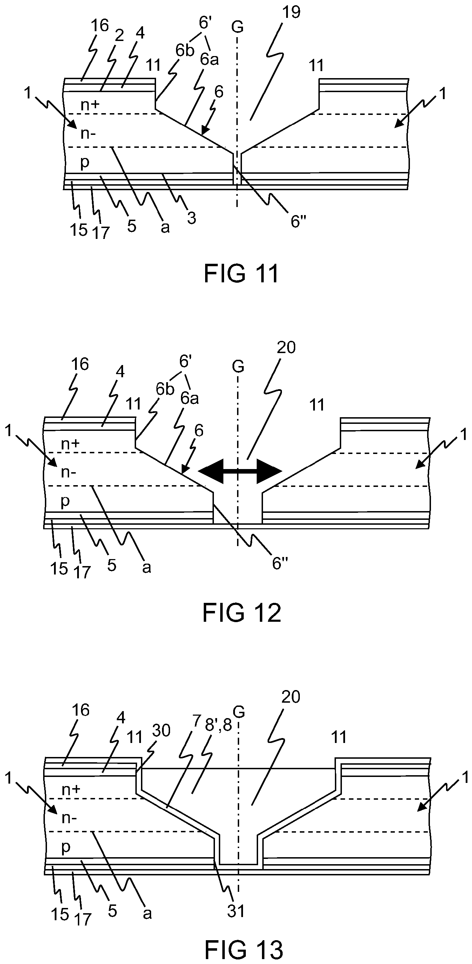

In einem weiteren Verfahrensschritt dessen Ergebnis in FIG 11 dargestellt ist, erfolgt eine Vereinzelung der Halbleiterchips 1 mittels Durchtrennung (z.B. mittels Durchsägen) des metallisierten bipolaren Halbleiterwafers 13' entlang der Grenzen G der Halbleiterchipbereiche 11, wodurch ein um den jeweiligen Halbleiterchip 1 umlaufender zweiter Randflächenbereich 6" des jeweiligen Halbleiterchips 1 ausgebildet wird. Der zweite Randflächenbereich 6" verläuft vorzugsweise senkrecht zur zweiten Hauptfläche 3 des metallisierten bipolaren Halbleiterwafers 13'.

In einem weiteren vorzugsweise durchzuführenden Verfahrensschritt wird die Folie 17, falls sie vorhanden ist, derart auseinandergezogen, dass die Abstände der Halbleiterchips 1 voneinander vergrößert werden, was in FIG 12 durch einen Doppelpfeil angedeutet ist.

In einem weiteren vorzugsweise durchzuführenden Verfahrensschritt erfolgt ein Reinigen des ersten und zweiten Randflächenbereichs 6' und 6", insbesondere durch Ätzen des ersten und zweiten Randflächenbereichs 6' und 6". Das Reinigen des ersten und zweiten Randflächenbereichs 6' und 6" kann dabei auch ein Glätten des ersten und zweiten Randflächenbereichs 6' und 6" beinhalten. Dieser Verfahrensschritt kann auch vor dem Verfahrensschritt des Auseinanderziehens der Folie 17 erfolgen. Das Ätzen des ersten und zweiten Randflächenbereichs 6' und 6" erfolgt vorzugsweise in Form von Plasmaätzen, insbesondere in Form von Plasmaätzen bei dem Schwefelhexafluorid als Ätzgas eingesetzt wird.

In einem weiteren Verfahrensschritt erfolgt ein Aufbringen einer Aluminiumoxidschicht (Al₂O₃) 7, die in FIG 13 dargestellt ist, auf die Oberfläche der um den jeweiligen Halbleiterchip 1 umlaufenden aus dem ersten und zweiten Randflächenbereich 6' und 6" bestehenden Randfläche 6 des jeweiligen Halbleiterchips 1. Die Aluminiumoxidschicht 7 wird insbesondere zumindest im Bereich des pn-Übergangs des jeweiligen Halbleiterchips 1 auf die Randfläche 6 aufgebracht und insbesondere zumindest auf den gesamten Randflächenabschnitt 6a aufgebracht. Die Aluminiumoxidschicht 7 wird vorzugsweise auf die gesamte Randfläche 6 des jeweiligen Halbleiterchips 1 aufgebracht, kann aber z.B. auch nur auf einen bestimmten Bereich der Randfläche 6 bzw. auf einen bestimmten Abschnitt der Randfläche 6, wie z.B. dem Randflächenabschnitt 6a aufgebracht werden. Die Aluminiumoxidschicht 7 weist vorzugsweise eine Dicke von 5nm bis 100nm, insbesondere eine Dicke von 15nm bis 25nm und insbesondere eine Dicke von 20nm auf. Das Aufbringen der Aluminiumoxidschicht auf die Oberfläche der Randfläche des jeweiligen Halbleiterchips erfolgt vorzugsweise mittels eines chemischen Gasphasenabscheideverfahrens, das insbesondere als ALD-Verfahren (Atomic Layer Deposition) ausgebildet ist.

Vorzugsweise reicht die erste Metallisierungsschicht 4 zumindest in einem Abschnitt der Randfläche 6 des jeweiligen Halbleiterchips 1 an die Randfläche 6 des jeweiligen Halbleiterchips 1 heran und die Aluminiumoxidschicht 7 wird vorzugsweise zumindest auf einem, an dem mindestens einen Abschnitt der Randfläche 6 des jeweiligen Halbleiterchips 1 angeordneten, Randflächenabschnitt 30 der ersten Metallisierungsschicht 4 aufgebracht. Im Rahmen des Ausführungsbeispiels gemäß FIG 8 bis FIG 15 reicht die gesamte Randfläche der ersten Metallisierungsschicht 4 an die Randfläche 6 des jeweiligen Halbleiterchips 1 heran und die Aluminiumoxidschicht 7 wird auf die gesamte Randfläche der ersten Metallisierungsschicht 4 aufgebracht. Vorzugsweise reicht die zweite Metallisierungsschicht 5 zumindest in einem Abschnitt der Randfläche 6 des jeweiligen Halbleiterchips 1 an die Randfläche 6 des Halbleiterchips 1 heran und die Aluminiumoxidschicht 7 wird vorzugsweise zumindest auf einem, an dem mindestens einen Abschnitt der Randfläche 6 des jeweiligen Halbleiterchips 1 angeordneten, Randflächenabschnitt 31 der zweiten Metallisierungsschicht 5 aufgebracht. Im Rahmen des Ausführungsbeispiels gemäß FIG 8 bis FIG 15 reicht die gesamte Randfläche der zweiten Metallisierungsschicht 5 an die Randfläche 6 des jeweiligen Halbleiterchips 1 heran und die Aluminiumoxidschicht 7 wird auf die gesamte Randfläche der zweiten Metallisierungsschicht 5 aufgebracht.

In einem weiteren durchzuführenden Verfahrensschritt erfolgt ein Aufbringen eines unvernetzten organischen Materials 8' auf die Oberfläche der Aluminiumoxidschicht 7 und ein Vernetzen des unvernetzten organischen Materials 8'. Im Rahmen des Ausführungsbeispiels werden hierzu entlang der Grenzen G zwischen den Halbleiterchips 1 verlaufende Gräben 20 mit einem unvernetzten organischen Material 8' verfüllt und das unvernetzte organische Materials 8' anschließend vernetzt, so dass sich ein vernetztes organisches Material 8 ausbildet. Das vernetzte organische Material 8 ist nicht elektrisch leitet. Das vernetzte organische Material 8 weist vorzugsweise in paralleler Richtung X zur zweiten Hauptfläche 3 des jeweiligen Halbleiterchips 1 eine durchschnittliche Dicke von 0,5µm bis 2000µm, insbesondere von 1µm bis 20µm auf.

Das unvernetzte organische Material 8', ist vorzugsweise als unvernetzter Silikonkautschuk, als unvernetztes Polyimid oder als unvernetztes Epoxidharz ausgebildet. Das jeweilige vernetzte organischen Material 8 ist dann jeweilig entsprechend als vernetzter Silikonkautschuk, als vernetztes Polyimid oder als vernetztes Epoxidharz ausgebildet. Der vernetzte Silikonkautschuk besteht im Allgemeinen im Wesentlichen aus Polysiloxan, insbesondere aus Polysiloxan. Das unvernetzte organische Material 8' weist in seinem unvernetzten Zustand eine flüssige oder gelförmige Konsistenz auf und wird z.B. durch Verdunstung und/oder Hitzeeinwirkung und/oder Lichteinwirkung vernetzt. Die Vernetzung geschieht im allgemeinen durch Polymerisation bzw. Polykondensation. Das vernetzte organische Material 8 weist, abhängig vom organischen Material, eine gummiähnliche oder duroplastische Konsistenz auf.

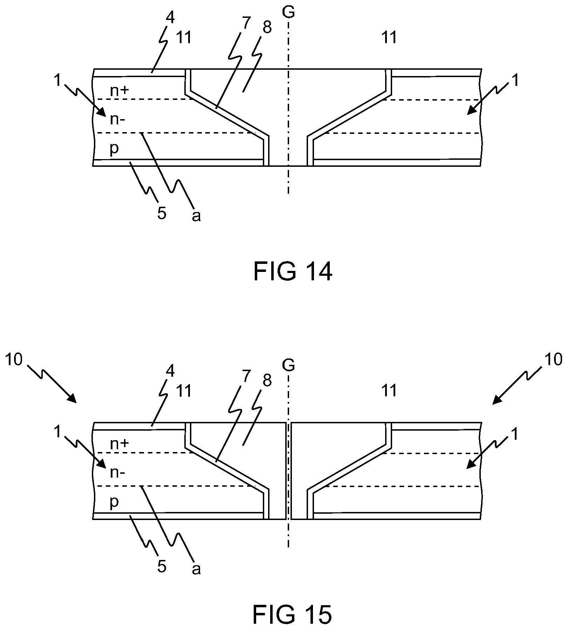

In einem weiteren vorzugsweise durchzuführenden Verfahrensschritt dessen Ergebnis in FIG 14 dargestellt ist, erfolgt falls vorhanden ein Entfernen der Folie 17 und der ersten und zweiten Harzschicht 15 und 16. Falls, wie beim Ausführungsbeispiel, beim Aufbringen der Aluminiumoxidschicht 7, die Aluminiumoxidschicht 7 auch auf die erste Harzschicht 15 aufgebracht wurde, wird auch die auf die erste Harzschicht 15 aufgebrachte Aluminiumoxidschicht 7 entfernt. Das Entfernen kann dabei z.B. durch mechanische Bearbeitung und durch Lösungsmittel erfolgen.

In einem weiteren Verfahrensschritt dessen Ergebnis in FIG 15 dargestellt ist, erfolgt, falls die Halbleiterchips 1 noch direkt oder indirekt über mindestens einen Werkstoff entlang der Grenzen G der Halbleiterchipbereiche 11 miteinander verbunden sind, ein Durchtrennen des mindestens einen Werkstoffs entlang der Grenzen G der Halbleiterchipbereiche 11. Hierdurch wird eine Vereinzelung der Halbleiterbauelemente 10 durchgeführt, falls diese nicht schon durch die Durchführung von vorhergehenden Verfahrensschritten bereits vereinzelt sind. Im Rahmen des Ausführungsbeispiel sind die Halbleiterchips 1 noch über das vernetzte organische Material 8 miteinander verbunden, so dass in diesem Verfahrensschritt ein Durchtrennen des vernetzten organischen Materials 8 entlang der Grenzen G der Halbleiterchipbereiche 11 erfolgt. Wenn z.B. die Folie 17 noch nicht zuvor entfernt wurde, wird zusätzlich noch die Folie 17 entlang der Grenzen G der Halbleiterchipbereiche 11 durchtrennt. Weiterhin kann aber z.B. auch das unvernetzte organische Material 8' derart auf die Oberfläche der Aluminiumoxidschicht 7 aufgebracht worden sein, dass das vernetzte organische Material 8 die Halbleiterchipbereiche 11 nicht miteinander verbindet, so dass dieser Verfahrensschritt z.B. in diesem Fall entfallen kann.

Es sei an dieser Stelle angemerkt, dass selbstverständlich Merkmale von verschiedenen Ausführungsbeispielen der Erfindung, sofern sich die Merkmale nicht gegenseitig ausschließen, beliebig miteinander kombiniert werden können.

## Patentansprüche

1. Halbleiterbauelement mit einem MESA-förmigen bipolaren Halbleiterchip (1), wobei auf einer ersten Hauptfläche (2) des Halbleiterchips (1) eine erste Metallisierungsschicht (4) angeordnet ist und auf einer der ersten Hauptfläche (2) des Halbleiterchips (1) gegenüberliegend angeordneten zweiten Hauptfläche (3) des Halbleiterchips (1) eine zweite Metallisierungsschicht (5) angeordnet ist, **dadurch gekennzeichnet, dass** auf einer um den Halbleiterchip (1) umlaufenden, die erste und zweite Hauptfläche (2,3) verbindenden Randfläche (6) des Halbleiterchips (1) eine Aluminiumoxidschicht (7) angeordnet ist, wobei die Aluminiumoxidschicht (7) auf der gesamten Randfläche (6) des Halbleiterchips (1) angeordnet ist, wobei auf der Oberfläche der Aluminiumoxidschicht (7) eine aus einem vernetzten organischen Material bestehende Schicht (8) angeordnet ist.

2. Halbleiterbauelement nach Anspruch 1, **dadurch gekennzeichnet, dass** die erste Metallisierungsschicht (4) zumindest in einem Abschnitt der Randfläche (6) des Halbleiterchips (1) an die Randfläche (6) des Halbleiterchips (1) heranreicht und die Aluminiumoxidschicht (7) auf zumindest einem, an dem mindestens einen Abschnitt der Randfläche (6) des Halbleiterchips (1) angeordneten, Randflächenabschnitt (30) der ersten Metallisierungsschicht (4) angeordnet ist.

3. Halbleiterbauelement nach einem der vorhergehenden Ansprüche, **dadurch gekennzeichnet, dass** die zweite Metallisierungsschicht (5) zumindest in einem Abschnitt der Randfläche (6) des Halbleiterchips (1) an die Randfläche (6) des Halbleiterchips (1) heranreicht und die Aluminiumoxidschicht (7) auf zumindest einem, an dem mindestens einen Abschnitt der Randfläche (6) des Halbleiterchips (1) angeordneten, Randflächenabschnitt (31) der zweiten Metallisierungsschicht (5) angeordnet ist.

4. Halbleiterbauelement nach einem der vorhergehenden Ansprüche, **dadurch gekennzeichnet, dass** die aus einem vernetzten organischen Material bestehende Schicht (8) auf der gesamten Oberfläche der Aluminiumoxidschicht (7) angeordnet ist.

5. Halbleiterbauelement nach einem der vorhergehende Ansprüche, **dadurch gekennzeichnet, dass** das vernetzte organische Material als vernetzter Silikonkautschuk, als vernetztes Polyimid oder als vernetztes Epoxidharz ausgebildet ist.

6. Halbleiterbauelement nach einem der vorhergehenden Ansprüche, **dadurch gekennzeichnet, dass** der bipolare Halbleiterchip als Diode, Thyristor oder Bipolartransistor ausgebildet ist.

7. Verfahren zur Herstellung von Halbleiterbauelementen mit MESA-förmigen bipolaren Halbleiterchips mit folgenden Verfahrensschritten:
a) Bereitstellen eines bipolaren Halbleiterwafers (13), wobei dem bipolaren Halbleiterwafer (13) Halbleiterchipbereiche (11) zugeordnet sind, an denen jeweilig ein Halbleiterchip (1) ausgebildet werden soll,
b) Ausbilden eines metallisierten bipolaren Halbleiterwafers (13') durch Aufbringen einer ersten Metallisierungsschicht (4) auf eine erste Hauptfläche (2) des bipolaren Halbleiterwafers (13) zumindest in einem jeweiligen ersten Teilbereich (12) der Halbleiterchipbereiche (11) und Aufbringen einer zweiten Metallisierungsschicht (5) auf einer der ersten Hauptfläche (2) des bipolaren Halbleiterwafers (13) gegenüberliegend angeordneten zweiten Hauptfläche (3) des bipolaren Halbleiterwafers (13) zumindest in einem jeweiligen zweiten Teilbereich (14) der Halbleiterchipbereiche (11),
c) Ausbildung von Ausnehmungen (19) im metallisierten bipolaren Halbleiterwafer (13') entlang der Grenzen (G) der Halbleiterchipbereiche (11), wodurch sich in einem Waferverbund miteinander verbundene Halbleiterchips (1) ausbilden, wobei die Ausnehmungen (19) eine derartige Form aufweisen, dass ein um den jeweiligen Halbleiterchip (1) umlaufender erster Randflächenbereich (6') des jeweiligen Halbleiterchips (1) ausgebildet wird, der mindestens einen zu der ersten Hauptfläche (2) des bipolaren Halbleiterwafers (13) schräg oder konkav verlaufenden Randflächenabschnitt (6a) aufweist,
d) Vereinzelung der Halbleiterchips (1) mittels Durchtrennung des metallisierten bipolaren Halbleiterwafers (13') entlang der Grenzen (G) der Halbleiterchipbereiche (11), wodurch ein um den jeweiligen Halbleiterchip (1) umlaufender zweiter Randflächenbereich (6") des jeweiligen Halbleiterchips (1) ausgebildet wird, **gekennzeichnet durch** die Schritte:
e) Aufbringen einer Aluminiumoxidschicht (7) auf die Oberfläche einer um den jeweiligen Halbleiterchip (1) umlaufenden aus dem ersten und zweiten Randflächenbereich (6',6") bestehenden Randfläche (6) des jeweiligen Halbleiterchips (1), wobei die Aluminiumoxidschicht (7) auf der gesamten Randfläche (6) des Halbleiterchips (1) aufgebracht wird, und
f) Aufbringen eines unvernetzten organischen Materials (8') auf die Oberfläche der Aluminiumoxidschicht (7) und Vernetzen des unvernetzten organischen Materials (8').

8. Verfahren nach Anspruch 7, **dadurch gekennzeichnet, dass** das unvernetzte organische Material (8') als unvernetzter Silikonkautschuk und das vernetzte organische Material (8) als vernetzter Silikonkautschuk ausgebildet ist, oder dass das unvernetzte organische Material (8') als unvernetztes Polyimid und das vernetzte organische Material (8) als vernetztes Polyimid ausgebildet ist, oder dass das unvernetzte organische Material (8') als unvernetztes Epoxidharz und das vernetzte organische Material (8) als vernetztes Epoxidharz ausgebildet ist.

9. Verfahren nach einem der Ansprüche 7 oder 8, wobei zwischen Verfahrensschritt d) und e) folgender Verfahrensschritt erfolgt:
d1) Reinigen des ersten und zweiten Randflächenbereichs (6',6"), insbesondere durch Ätzen des ersten und zweiten Randflächenbereichs (6',6").

10. Verfahren nach einem der Ansprüche 7 bis 9, wobei zwischen Verfahrensschritt b) und c) oder zwischen Verfahrensschritt c) und d) ein Verbinden der zweiten Metallisierungsschicht (5) mit einer Folie (17) erfolgt und unmittelbar nach Verfahrensschritt d) die Folie (17) derart auseinandergezogen wird, dass die Abstände der Halbleiterchips (1) voneinander vergrößert werden.

11. Verfahren nach einem der Ansprüche 7 bis 10, wobei im Verfahrensschritt e) das Aufbringen der Aluminiumoxidschicht (7) auf die Oberfläche der Randfläche (6) des jeweiligen Halbleiterchips (1) mittels eines chemischen Gasphasenabscheideverfahrens, das insbesondere als Atomic Layer Deposition Verfahren ausgebildet ist, durchgeführt wird.

12. Verfahren nach einem der Ansprüche 7 bis 11, mit folgendem Verfahrensschritt am Ende des Verfahrens, falls die Halbleiterchips (1) noch direkt oder indirekt über mindestens einen Werkstoff (8) entlang der Grenzen (G) der Halbleiterchipbereiche (11) miteinander verbunden sind:
g) Durchtrennen des mindestens einen Werkstoffs (8) entlang der Grenzen (G) der Halbleiterchipbereiche (11).

## Claims

1. Semiconductor component comprising a MESA-shaped bipolar semiconductor chip (1), wherein a first metallization layer (4) is arranged on a first main surface (2) of the semiconductor chip (1) and a second metallization layer (5) is arranged on a second main surface (3) of the semiconductor chip (1), said second main surface being arranged opposite the first main surface (2) of the semiconductor chip (1), **characterized in that** an aluminium oxide layer (7) is arranged on an edge surface (6) of the semiconductor chip (1) that extends circumferentially around the semiconductor chip (1) and connects the first and second main surfaces (2, 3), wherein the aluminium oxide layer (7) is arranged on the entire edge surface (6) of the semiconductor chip (1), wherein a layer (8) consisting of a crosslinked organic material is arranged on the surface of the aluminium oxide layer (7) .

2. Semiconductor component according to Claim 1, **characterized in that** the first metallization layer (4) extends to the edge surface (6) of the semiconductor chip (1) at least in a section of the edge surface (6) of the semiconductor chip (1), and the aluminium oxide layer (7) is arranged on at least one edge surface section (30) of the first metallization layer (4) that is arranged at the at least one section of the edge surface (6) of the semiconductor chip (1).

3. Semiconductor component according to any of the preceding claims, **characterized in that** the second metallization layer (5) extends to the edge surface (6) of the semiconductor chip (1) at least in a section of the edge surface (6) of the semiconductor chip (1), and the aluminium oxide layer (7) is arranged on at least one edge surface section (31) of the second metallization layer (5) that is arranged at the at least one section of the edge surface (6) of the semiconductor chip (1).

4. Semiconductor component according to any of the preceding claims, **characterized in that** the layer (8) consisting of a crosslinked organic material is arranged on the entire surface of the aluminium oxide layer (7).

5. Semiconductor component according to any of the preceding claims, **characterized in that** the crosslinked organic material is embodied as crosslinked silicone rubber, as crosslinked polyimide or as crosslinked epoxy resin.

6. Semiconductor component according to any of the preceding claims, **characterized in that** the bipolar semiconductor chip is embodied as a diode, thyristor or bipolar transistor.

7. Method for producing semiconductor components comprising MESA-shaped bipolar semiconductor chips, comprising the following method steps:
a) providing a bipolar semiconductor wafer (13) wherein the bipolar semiconductor wafer (13) is assigned semiconductor chip regions (11) at which a semiconductor chip (1) is intended respectively to be formed,
b) forming a metallized bipolar semiconductor wafer (13') by applying a first metallization layer (4) to a first main surface (2) of the bipolar semiconductor wafer (13) at least in a respective first partial region (12) of the semiconductor chip regions (11) and applying a second metallization layer (5) on a second main surface (3) of the bipolar semiconductor wafer (13), said second main surface being arranged opposite the first main surface (2) of the bipolar semiconductor wafer (13), at least in a respective second partial region (14) of the semiconductor chip regions (11),
c) forming cutouts (19) in the metallized bipolar semiconductor wafer (13') along the boundaries (G) of the semiconductor chip regions (11), as a result of which semiconductor chips (1) connected to one another in a wafer assemblage are formed, wherein the cutouts (19) have a shape such that a first edge surface region (6') of the respective semiconductor chip (1) is formed which extends circumferentially around the respective semiconductor chip (1) and which has at least one edge surface section (6a) running obliquely or concavely with respect to the first main surface (2) of the bipolar semiconductor wafer (13),
d) singulating the semiconductor chips (1) by means of severing the metallized bipolar semiconductor wafer (13') along the boundaries (G) of the semiconductor chip regions (11), as a result of which a second edge surface region (6") of the respective semiconductor chip (1) is formed which extends circumferentially around the respective semiconductor chip (1), **characterized by** the steps of:
e) applying an aluminium oxide layer (7) to the surface of an edge surface (6) of the respective semiconductor chip (1) that extends circumferentially around the respective semiconductor chip (1) and consists of the first and second edge surface regions (6', 6"), wherein the aluminium oxide layer (7) is applied to the entire edge surface (6) of the semiconductor chip (1), and
f) applying an uncrosslinked organic material (8') to the surface of the aluminium oxide layer (7) and crosslinking the uncrosslinked organic material (8').

8. Method according to Claim 7, **characterized in that** the uncrosslinked organic material (8') is embodied as uncrosslinked silicone rubber and the crosslinked organic material (8) is embodied as crosslinked silicone rubber, or **in that** the uncrosslinked organic material (8') is embodied as uncrosslinked polyimide and the crosslinked organic material (8) is embodied as crosslinked polyimide, or **in that** the uncrosslinked organic material (8') is embodied as uncrosslinked epoxy resin and the crosslinked organic material (8) is embodied as crosslinked epoxy resin.

9. Method according to either of Claims 7 and 8, wherein the following method step takes place between method steps d) and e):
d1) cleaning the first and second edge surface regions (6', 6"), in particular by etching the first and second edge surface regions (6', 6").

10. Method according to any of Claims 7 to 9, wherein, between method steps b) and c) or between method steps c) and d), connecting the second metallization layer (5) to a film (17) is performed and, directly after method step d), the film (17) is pulled apart in such a way that the distances between the semiconductor chips (1) are increased.

11. Method according to any of Claims 7 to 10, wherein, in method step e), applying the aluminium oxide layer (7) to the surface of the edge surface (6) of the respective semiconductor chip (1) is carried out by means of a chemical vapour deposition method embodied in particular as an Atomic Layer Deposition method.

12. Method according to any of Claims 7 to 11, comprising the following method step at the end of the method if the semiconductor chips (1) are still connected to one another directly or indirectly via at least one material (8) along the boundaries (G) of the semiconductor chip regions (11):
g) severing the at least one material (8) along the boundaries (G) of the semiconductor chip regions (11) .

## Revendications

1. Composant semi-conducteur, pourvu d'une puce semi-conductrice (1) bipolaire en forme de MESA, sur une première surface principale (2) de la puce semi-conductrice (1) étant placée une première couche de métallisation (4) et sur une deuxième surface principale (3) de la puce semi-conductrice (1) qui est disposée à l'opposé de la première surface principale (2) de la puce semi-conductrice (1) étant placée une deuxième couche de métallisation (5), **caractérisé en ce que** sur une surface marginale (6) de la puce semi-conductrice (1) périphérique autour de la puce semi-conductrice (1), reliant la première et la deuxième surface principale (2, 3) est placée une couche d'oxyde d'aluminium (7), la couche d'oxyde d'aluminium (7) étant placée sur toute la surface marginale (6) de la puce semi-conductrice (1), sur la surface de la couche d'oxyde d'aluminium (7) étant placée une couche (8) constituée d'une matière organique réticulée.

2. Composant semi-conducteur selon la revendication 1, **caractérisé en ce qu'**au moins dans une section de la surface marginale (6) de la puce semi-conductrice (1), la première couche de métallisation (4) arrive jusqu'à la surface marginale (6) de la puce semi-conductrice (1) et la couche d'oxyde d'aluminium (7) est placée sur au moins une section de surface marginale (30), placée sur au moins une section de la surface marginale (6) de la puce semi-conductrice (1), de la première couche de métallisation (4).

3. Composant semi-conducteur selon l'une quelconque des revendications précédentes, **caractérisé en ce qu'**au moins dans une section de la surface marginale (6) de la puce semi-conductrice (1), la deuxième couche de métallisation (5) arrive jusqu'à la surface marginale (6) de la puce semi-conductrice (1) et la couche d'oxyde d'aluminium (7) est placée sur au moins une section de surface marginale (31), placée la surface marginale (6) de la puce semi-conductrice (1), de la deuxième couche de métallisation (5) sur l'au moins une section de.

4. Composant semi-conducteur selon l'une quelconque des revendications précédentes, **caractérisé en ce que** la couche (8) constituée d'une matière organique réticulée est placée sur toute la surface de la couche d'oxyde d'aluminium (7).

5. Composant semi-conducteur selon l'une quelconque des revendications précédentes, **caractérisé en ce que** la matière organique réticulée est conçue sous la forme de caoutchouc de silicone réticulé, de polyimide réticulé ou de résine époxy réticulée.

6. Composant semi-conducteur selon l'une quelconque des revendications précédentes, **caractérisé en ce que** la puce semi-conductrice bipolaire est conçue sous la forme d'une diode, d'un thyristor ou d'un transistor bipolaire.

7. Procédé, destiné à fabriquer des composants semiconducteurs pourvus de puces semi-conductrices bipolaires en forme de MESA, comprenant les étapes de procédé suivantes, consistant à :
a) mettre à disposition une tranche de semi-conducteur bipolaire (13), à la tranche de semi-conducteur bipolaire (13) étant associées des zones de puces semi-conductrices (11) sur lesquelles respectivement une puce semi-conductrice (1) est censée être conçue,
b) créer une tranche de semi-conducteur bipolaire (13') métallisée, par application d'une première couche de métallisation (4) sur une première surface principale (2) de la tranche de semi-conducteur bipolaire (13), au moins dans une première zone partielle (12) respective des zones de puces semi-conductrices (11), et par application d'une deuxième couche de métallisation (5) sur une deuxième surface principale (3) de la tranche de semi-conducteur bipolaire (13) placée à l'opposée de la première surface principale (2) de la tranche de semi-conducteur bipolaire (13), au moins dans une deuxième zone partielle (14) respective des zones de puces semi-conductrices (11),
c) créer des évidements (19) dans la tranche métallisée de semi-conducteur bipolaire (13'), le long des limites (G) des zones de puces semi-conductrices (11), suite à quoi se forment des puces semi-conductrices (1) reliées les unes aux autres en une tranche composite,
les évidements (19) présentant une forme telle, qu'une première zone de surface marginale (6') de la puce semi-conductrice (1) respective, périphérique autour de la puce semi-conductrice (1) respective soit conçue, qui comporte au moins une section de surface marginale (6a) s'étendant obliquement ou sous forme concave par rapport à la première surface principale (2) de la tranche de semi-conducteur bipolaire (13),
d) désolidariser les puces semi-conductrices (1) par sectionnement de la tranche métallisée de semi-conducteur bipolaire (13') le long des limites (G) des zones de puces semi-conductrices (11), suite à quoi est conçue une deuxième zone de surface marginale (6") de la puce semi-conductrice (1) respective, périphérique autour de la puce semi-conductrice (1) respective, **caractérisé par** les étapes consistant à :
e) appliquer une couche d'oxyde d'aluminium (7) sur la surface d'une surface marginale (6) de la puce semi-conductrice (1) respective, périphérique autour de la puce semi-conductrice (1) respective, constituée de la première et deuxième zone de surface marginale (6', 6"), la couche d'oxyde d'aluminium (7) étant appliquée sur toute la surface marginale (6) de la puce semi-conductrice (1), et
f) appliquer une matière organique (8') non réticulée sur la surface de la couche d'oxyde d'aluminium (7) et réticuler la matière organique (8') non réticulée.

8. Procédé selon la revendication 7, **caractérisé en ce que** la matière organique (8') non réticulée est conçue sous la forme d'un caoutchouc de silicone non réticulé et la matière organique (8) réticulée est conçue sous la forme d'un caoutchouc de silicone réticulé, ou **en ce que** la matière organique (8') non réticulée est conçue sous la forme d'un polyimide non réticulé et la matière organique (8) réticulée est conçue sous la forme d'un polyimide réticulé, ou **en ce que** la matière organique (8') non réticulée est conçue sous la forme d'une résine époxy non réticulée et la matière organique (8) réticulée est conçue sous la forme d'une résine époxy réticulée.

9. Procédé selon l'une quelconque des revendications 7 ou 8, entre les étapes de procédé d) et e) étant effectuée l'étape de procédé suivante, consistant à :
d1) nettoyer la première et deuxième zone de surface marginale (6', 6"), notamment par décapage de la première et deuxième zone de surface marginale (6', 6").

10. Procédé selon l'une quelconque des revendications 7 à 9, entre les étapes de procédé b) et c) ou entre les étapes de procédé c) et d) étant effectuée une liaison de la deuxième couche de métallisation (5) avec un film (17) et immédiatement après l'étape de procédé d), le film (17) étant étiré de telle sorte que les écarts mutuels entre les puces semi-conductrices (1) soient agrandis.

11. Procédé selon l'une quelconque des revendications 7 à 10, dans l'étape de procédé e) étant réalisée l'application de la couche d'oxyde d'aluminium (7) sur la surface de la surface marginale (6) de la puce semi-conductrice (1) respective, au moyen d'un procédé de dépôt chimique en phase vapeur, qui est conçu notamment sous la forme d'un procédé par Atomic Layer Deposition.

12. Procédé selon l'une quelconque des revendications 7 à 11, comprenant, à la fin du procédé, si les puces semi-conductrices (1) sont encore reliées entre elles directement ou indirectement par l'intermédiaire d'au moins un matériau (8) le long des limites (G) des zones de puces semi-conductrices (11), l'étape de procédé suivante consistant à :
g) sectionner l'au moins un matériau (8) le long des limites (G) des zones de puces semi-conductrices (11).
